# EUROPEAN PATENT APPLICATION

(11) **EP 4 099 380 A1**
(43) Date of publication of application: **07.12.2022**
(21) Application number: 21177477.3
(22) Date of filing: 02.06.2021
(51) Int. Cl.: H01L 23/42, H05K 7/20

(54) **SHELL STRUCTURES FOR THERMAL INTERFACE MATERIALS**

(71) Applicant: 3M Innovative Properties Co., St. Paul, MN 55133-3427 (US)
(72) Inventor: Gaide, Tom, 50674 Köln (DE); Ostrowski, Karoline Anna, 40223 Düsseldorf (DE); Tegeder, Patricia, 40211 Düsseldorf (DE); Eichler, Jens, 41564 Kaarst (DE); Brand, Simon, 41464 Neuss (DE)
(74) Representative: Mathys & Squire

(57) **Abstract**

The present invention relates to a thermally conductive structure comprising a first and a second element, a shell structure between the first element and the second element, wherein the shell structure, the first element and the second element define an enclosed space, and a thermal interface material comprised in the enclosed space.

## Description

### Field of the invention

The present invention relates to a thermally conductive structure comprising a first and a second element, a shell structure between the first element and the second element, wherein the shell structure, the first element and the second element define an enclosed space, and a thermal interface material comprised in the enclosed space. The present invention further relates to methods for tailoring the shell structure and making a thermally conductive structure.

### Background

Traditionally, thermal interface materials (TIM) can be segmented into thermally conductive pads and sheets (e.g., tapes), liquid single component (1K) gap fillers and liquid two-component (2K) gap fillers, adhesive 1K or 2K compounds, and greases. Most often the TIM consists of a polymer matrix comprising a high amount of thermally conductive particles of various shapes.

One major limitation is the restriction in form factors currently addressable with these TIM's. TIM's are for example available in the form of pads. Such pads are relatively easy to handle and, since they are already in their final chemical stage, remain in their initial shape. However, due to their limited compressibility and further processing limitations, they are only available in a limited thickness. Also, they can only sustain generally up to 30 % compression in order to mitigate unevenness and tolerance levels of the components into which they are introduced.

On the other hand, liquid TIM's are commercially available. They can be easily applied (e.g., by robotic dispension or other means), and can fill large gaps. Also, they provide a high degree of flexibility so that they can adapt to any unevenness and tolerance levels of the components into which they are introduced. However, they cannot be controlled in their shapes other than by the surrounding components, which are not part of the TIM's as such.

Due to the advancement of areas like automotive electrification batteries or other electronic components, optimum use of space is essential to increase system performance. Therefore, new form factors of TIM's are needed to allow new designs. New form factors are addressed by the present invention.

Additionally, the challenge to align highly thermally conductive particles (e.g., hexagonal boron nitride or graphite) is well documented in the literature. These fillers offer high conductivity if oriented in the right direction (most often through-plane) but prefer orientation in the opposite direction (most often in-plane) due to their shape. In the case of TIM's in the form of pads and sheets (e.g., tapes) the orientation is fixed based on their processing and can therefore be controlled by the supplier. In the case of liquid TIM's, the orientation happens during the application at the customer, and is therefore out of control for the supplier.

By controlling the orientation, higher performance TIM's can be obtained with improved thermal pathways. This addresses challenges of the engineers regarding higher power density or higher demanding operating conditions (e.g., in fast charging of automotive electrification batteries). Overall, the fast-growing thermal interface market is still in desperate need for new innovations, in particular in the field of automotive applications.

3D-printing technology offers new opportunities for material and design optimizations.

US 8,178,033 B2 describes 3D-printing of outer shells and the injection of a liquid material into the shell. The materials are disclosed for use in aerospace application. US 2019/373773 A1 describes the use of two thermally conductive plastics with varying hardness. Both materials are part of one component. Only one material forms an interfacial layer, while the other is the main portion of a heat sink (e.g., a cooling radiator). US 2004/065410 A1 describes the dispension of a thermal interface material into a cavity of an electronic construction. US 2011/048795 A1 describes surfaces with an electronic part disposed thereon, a cover enclosing the electronic part on the surface, and a thermal interface material surrounding the electronic part under the cover.

According to the present invention, these fields of TIM design and 3D-printing technology are combined into providing new form factors for thermally conductive structures to further optimize heat dissipation in electronic systems and devices.

The present invention solves the above-mentioned problems. In particular, the present invention offers the possibility to use liquid and other highly flexible TIM's in order to obtain excellent contact between the TIM and a contact surface, irrespective of the shape or contour of the surface, while simultaneously keeping the TIM to a predetermined expansion. The present invention further allows for the provision of TIM layers with a high thickness.

### Summary of the invention

The present invention relates to a thermally conductive structure comprising
a. a first element having at least a first major surface;
b. a second element having at least a first major surface;
c. a shell structure between the first element and the second element, and in contact with the first major surface of the first element and the first major surface of the second element,
   wherein the shell structure, the first major surface of the first element and the first major surface of the second element define an enclosed space,
   wherein the shell structure comprises at least one first opening which defines at least one first interface area to the first major surface of the first element,
   wherein the shell structure comprises at least one second opening which defines at least one second interface area to the first major surface of the second element,
   wherein the shell structure comprises at least one third opening between the first element and the second element; and
d. a thermal interface material (TIM) comprised in the enclosed space, and in direct contact with the first element via the at least one first interface area and with the second element via the at least one second interface area.

The present invention further relates to a method of tailoring a shell structure for thermal interface materials comprising
i. providing a first element and a second element, each having a first major surface, with a space between the first major surface of the first element and the first major surface of the second element;
ii. determining the three-dimensional expansion of the space;
iii. forming a shell structure suitable to fit into the space,
   so that the shell structure when inserted into the space is in contact with the first major surface of the first element and the first major surface of the second element,
   wherein the shell structure, the first major surface of the first element and the first major surface of the second element define an enclosed space,
   wherein the shell structure comprises at least one first opening which defines at least one first interface area to the first major surface of the first element,
   wherein the shell structure comprises at least one second opening which defines at least one second interface area to the first major surface of the second element,
   wherein the shell structure comprises at least one third opening between the first element and the second element.

The present invention further relates to a method of making a heat transfer component comprising
a) providing a first element and a second element, each having a first major surface,
b) providing a shell structure;
c) providing a liquid thermal interface material;
d) assembling the first element, the second element, the shell structure and the liquid thermal interface material, so that the shell structure is in a space between the first major surface of the first element and the first major surface of the second element and in contact with the first major surface of the first element and the first major surface of the second element,
   wherein the shell structure, the first major surface of the first element and first major surface of the second element define an enclosed space,
   wherein the shell structure comprises at least one first opening which defines at least one first interface area to the first major surface of the first element,
   wherein the shell structure comprises at least one second opening which defines at least one second interface area to the first major surface of the second element,
   wherein the shell structure comprises at least one third opening between the first element and the second element, and
   wherein the liquid thermal interface material is comprised in the enclosed space, and in direct contact with the first element via the at least one first interface area and with the second element via the at least one second interface area; and
e) optionally, curing the liquid thermal interface material.

The present invention further relates to an electronic device comprising a thermally conductive structure as described herein.

### Summary of the Figures

Fig. 1 is a side view of a thermally conductive structure.
Fig. 2 is a detailed side view of the first and second interface areas of the thermally conductive structure of Fig. 1.
Fig. 3a-d show different surface structures of the first major surface of the first element.
Fig. 4a-d show different surface structures of the first major surface of the second element.
Fig. 5a is a side view of a thermally conductive structure comprising alignable thermally conductive particles.
Fig. 5b-c shows a shell structure having internal structures.
Fig. 6 is a side view of a thermally conductive structure having different first and second interface areas.
Fig. 7 is a detailed side view of the first and second interface areas of the thermally conductive structure of Fig. 6.
Fig. 8 is a side view of a thermally conductive structure having pluralities of first and second openings.
Fig. 9 is a side view of a thermally conductive structure.
Fig. 10a-b show cylinder-shaped shell structures.
Fig. 11a-b show cylinder-shaped shell structures with inner design features.
Fig. 12a-b show the process of filling a shell structure with a TIM.
Fig. 13 shows the top view of a cuboid shell structure filled with a TIM.
Fig. 14 shows a side view of the first and second elements.

### Detailed description of the invention

The present invention relates to the provision of thermally conductive structures and heat dissipation devices.

The abbreviation "TIM" as used herein means "thermal interface material".

Thermal conductivity is a material property describing the ability of a given material to transfer heat through internal heat conduction. The thermal conductivity does not account for interfacial effects that may impede heat flow. The thermal conductivity can be measured according to ASTM D5470-17. TIM's according to the present invention preferably have a thermal conductivity in the range of from 1-40 W/(m*K).

A "content" or a "percentage" specified herein and relating to an "amount" is by weight, unless otherwise specified.

The present invention relates to a thermally conductive structure comprising
a. a first element having at least a first major surface;
b. a second element having at least a first major surface;
c. a shell structure between the first element and the second element, and in contact with the first major surface of the first element and the first major surface of the second element,
   wherein the shell structure, the first major surface of the first element and the first major surface of the second element define an enclosed space,
   wherein the shell structure comprises at least one first opening which defines at least one first interface area to the first major surface of the first element,
   wherein the shell structure comprises at least one second opening which defines at least one second interface area to the first major surface of the second element,
   wherein the shell structure comprises at least one third opening between the first element and the second element; and
d. a thermal interface material (TIM) comprised in the enclosed space, and in direct contact with the first element via the at least one first interface area and with the second element via the at least one second interface area.

### Thermally conductive structure

The thermally conductive structure according to the present invention may be part of any device needing heat to be dissipated. According to the present invention, it may be preferred that the thermally conductive structure is part of an electronic device.

Examples for such electronic devices are all kinds of devices comprising semiconductor devices, transistors, CPU's (central processing units), GPU's (graphics processing units), COB (chips on board) LED's, CPU's coupled with a cooler, battery charging systems, battery systems including cells and electrical connections and antennas.

### First/second element

According to the present invention, the first element has at least a first major surface. Preferably, the first element has opposed first and second major surfaces.

The first element may for example be a heat generating component, i.e., a component whose temperature increases during use. To avoid, for example, overheating, the heat must then be dissipated from the element and/or device. Effective temperature dissipation may increase the lifetime of a device or elements thereof, its reliability, and its consistency during use.

The first element may be selected from the group consisting of CPU's, GPU's, battery elements, LED's, bus bars, antenna or other electrical components needing cooling.

According to the invention, at least part of the first major surface of the first element is a casing or substrate. For example, it may be preferred that batteries comprise a battery casing, e.g., made of aluminum. For example, it may be preferred that bus bars will connect the copper band conducting large amounts of electricity directly.

According to the present invention, the second element has at least a first major surface. Preferably, the second element has opposed first and second major surfaces.

The second element is preferably an element designed to dissipate heat, for example selected from substrates, heat sinks, e.g., coolers or fans, heat exchangers, and heat dissipators. For example, the second element surface may be a metal or ceramic surface. This is preferred for example in the upper shell of a cooling system, the top side of a heat radiator or the outer casing (which e.g. would be cooled by convection).

According to the invention, at least part of the first major surface of the first element, at least part of the first major surface of the second element, or at least part of both may comprise a functional layer. Suitable functional layers may for examples be primer layers (e,g, 3M^{™} VHB^{™} Tape Universal Primer UV), electrically insulating layers (e.g. Scotchcast ^{™} Electrical Resin 260), EMI protecting layers or tapes (e.g. 3M^{™} Electrically Conductive Adhesive Transfer Tape 9720S), corrosion protective coatings (e.g. 3M^{™} Scotchkote^{™} Epoxy Ceramic Surfacer FG 512) or processing aids like oils.

It may be preferred that at least part of the first major surface of the first element comprises a functional layer, preferably the first major surface of the first element is a functional layer. It may be preferred that at least part of the first major surface of the second element comprises a functional layer, preferably the first major surface of the second element is a functional layer.

The functional layers on the first and second elements may be the same or different. Preferably, the functional layer on the first element is the same as the functional layer on the second element. Preferably, the functional layer on the first element is different from the functional layer on the second element.

The first major surface of the first element and the first major surface of the second element may generally face in the same or in different directions. Preferably, the first major surface of the first element and the first major surface of the second element face each other, e.g., the first major surface of the first element faces upwards and the first major surface of the second element faces downwards, or the first major surface of the first element faces left and the first major surface of the second element faces right.

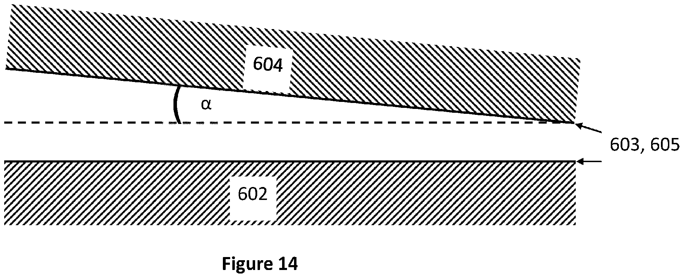

The first major surface of the first element and the first major surface of the second element may be parallel, i.e, the angle α between them is 0°. As exemplified in Figure 14, it is also possible that the first major surface 603 of the first element 602 and the first major surface 605 of the second element 603 are not parallel. The angle α may be in the range of from more than 0° to about 90°, for example from about 1 ° to about 45° or from about 5° to about 20°.

According to the present invention, the first major surface of the first element or the first major surface of the second element or both may be planar. A planar surface means that the curvature of the surface is zero.

The first major surface of the first element or the first major surface of the second element or both may be unstructured. According to the present invention that means that protrusions and cavities on the first major surface of the first element or the first major surface of the second element or both are each no larger than about 10 µm. This dimension identifies the largest dimension of each protrusion or cavity.

It is also possible according to the present invention that the first major surface of the first element or the first major surface of the second element, or both are structured. According to the present invention, that means that structural elements, e.g., protrusions or cavities or both, are comprised on the first major surface of the first element or the first major surface of the second element or both. Structural elements according to the invention are larger than about 10 µm. This dimension identifies the largest dimension of structural element. The structural elements can form a pattern or can be arranged irregularly on the first major surface of the first element or the first major surface of the second element or both. Also, the structural elements can be patterned in one area and irregularly arranged in another area of the first major surface of the first element or the first major surface of the second element or both.

The first major surface of the first element or the first major surface of the second element or both can have a combination of structured and unstructured areas.

According to the present invention, the first major surface of the first element or the first major surface of the second element or both may have a curvature unequal to zero, e.g., the first major surface of the first element or the first major surface of the second element or both may be concave or convex. For example, the first major surface of the first element or the first major surface of the second element or both are concave, or the first major surface of the first element or the first major surface of the second element or both are convex, or the first major surface of the first element is concave or convex and the first major surface of the second element is planar, or the first major surface of the first element is planar and the first major surface of the second element is concave or convex.

It is preferred that the first major surface of the first element and the first major surface of the second element are planar. It is preferred that the first element and the first major surface of the second element are unstructured.

Preferably, the shortest distance between the first major surface of the first element and the first major surface of the second element is in the range of from about 100 nm to about 250 mm, for example from about 1 mm to about 100 mm, more preferably from about 10 mm to about 50 mm.

### Shell structure

According to the present invention, the shell structure is in contact with the first major surface of the first element and the first major surface of the second element. The term "in contact" as used herein means direct contact or indirect contact via a contacting component. The shell structure may be in direct contact with the first major surface of the first element, with the first major surface of the second element, or with both. Preferably, the shell structure is in direct contact with the first major surface of the first element and with the first major surface of the second element.

It is possible according to the present invention that the shell structure is in contact with the first major surface of the first element, with the first major surface of the second element or both via a contacting component. The contacting component has two contact surfaces, wherein the first contact surface is the contact surface of the contacting component with the first major surface of the first or second element, and wherein the second contact surface is the contact surface of the contacting component with the shell structure.

It may be preferred that the shell structure is in contact with the first major surface of the first element, with the first major surface of the second element or both via a contacting component, e.g., when the respective first major surface is structured. In this case, the first contact surface of the contacting component has a structure which is inverse to the structure of the structured first major surface.

Suitable contacting components are for example adhesives (e.g. 3M^{™} Scotch-Weld^{™} Acrylic Adhesive DP8410NS), sealants (e.g. 3M^{™} Polyurethane Adhesive Sealant 560), thermally conductive materials (e.g. 3M^{™} Thermally Conductive Interface Tape), thermally insulating materials, electrically conductive materials (e.g. 3M^{™} Electrically Conductive Adhesive Transfer Tape 9720S), electrically insulating materials (e.g. 3M^{™} Thermally Conductive Interface Tape), electromagnetic shielding materials (e.g. 3M^{™} Electrically Conductive Adhesive Transfer Tape 9720S),, electromagnetic transparent materials, electromagnetic redirecting materials, and thermal interface materials. It may be preferred that the contacting component is the thermal interface material comprised in the enclosed space.

It may be preferred that the thickness of the contacting component is in the range of from 1 µm to 10 mm, preferably 100 µm to 1 mm.

The shell structure comprises at least one first opening which defines at least one first interface area to the first major surface of the first element. It may be preferred that the shell structure comprises a single first opening which defines a single first interface area to the first major surface of the first element. It may also be preferred that the shell structure comprises a plurality of first openings which define a plurality of first interface areas to the first major surface of the first element. The plurality of first openings may be patterned or arranged irregularly, preferably patterned.

The shell structure comprises at least one second opening which defines at least one second interface area to the first major surface of the second element. It may be preferred that the shell structure comprises a single second opening which defines a single second interface area to the first major surface of the second element. It may also be preferred that the shell structure comprises a plurality of second openings which define a plurality of second interface areas to the first major surface of the second element. The plurality of second openings may be patterned or arranged irregularly, preferably patterned.

The pattern of the plurality of first openings and the pattern of the plurality of second openings may be the same or different. For example, the pattern of the plurality of first openings and the pattern of the plurality of second openings is the same. For example, the pattern of the plurality of first openings and the pattern of the plurality of second openings is different.

It may be preferred according to the present invention that the shell structure comprises a single first opening which defines a single first interface area to the first major surface of the first element, and a plurality of second openings which define a plurality of second interface areas to the first major surface of the second element.

The openings may generally be of any shape.

Where the shell structure has a single first opening or a single second opening, its shape is preferably adapted to the shape of the shell structure. For example, the first and second openings of a cylindrical shell structure with a single first and a single second opening are circular, or the first and second openings of a cuboid shell structure with a single first and a single second opening are rectangular.

In pluralities of first openings or pluralities of second openings, the openings may be circular, rectangular, slit-shaped, elliptical, polygonal, conical or irregular, or form grid or mesh structures.

According to the present invention, the shell structure, the first major surface of the first element and the first major surface of the second element define an enclosed space. In the thermally conductive structure according to the present invention, the enclosed space is filled with the TIM.

According to the present invention, the shell structure comprises at least one third opening between the first element and the second element. The third opening does not define an interface area with the first element and with the second element. The third opening can generally have any shape. It may be preferred that the third opening includes a joint, e.g., to connect an injection device. It may be intended that the third opening is used to introduce the TIM into the enclosed space. However, it is also possible that the third opening functions as a vent if the TIM is introduced via the first or second opening.

The shell structure is preferably made of a 3D-printable shell material. Preferred shell materials are selected from metals, ceramics, polymers or polymer matrix composites. Where the shell material is a polymer or polymer matrix material, the polymer is preferably selected from the group consisting of poly(meth)acrylics, polyamides, nylons, acrylonitrile butadiene styrene (ABS), acrylonitrile styrene acrylates (ASA), polylactic acids (PLA), poly(lactic-co-glycolic acids), polycaprolactones (PCL), polycarbonates, polystyrenes, polyether ketone ketones (PEKK), polyether ether ketone (PEEK), polyphenyl sulfones (PPSF), polyanilines, polyvinyl ethers (PVE), epoxides, polyvinylidene fluorides (PVDF), polymethyl methacrylate (PMMA), polyacrylonitriles, polyurethanes, polyesters, polyether, polyolefins, polyphenylene oxides, thermoplastic polyurethanes (TPU), perfluoroalkoxy alkanes (PFA), polytetrafluoroethylene (PTFE), and any combinations or mixtures thereof. Where the shell material is a metal it is preferably copper, aluminum or bronze. Where the shell material is a ceramic it is preferably alumina, zirconium dioxide, silicon nitride, silicon carbide or mixtures thereof.

The shell structure may for example be thermally conductive, thermally insulating, electrically conductive, or electrically insulating. It may also be suitable that the shell structure is thermally and electrically conductive. It may also be suitable that the shell structure is thermally and electrically insulating. It may also be suitable that the shell structure is thermally insulating and electrically conductive. It may also be suitable that the shell structure is thermally conductive and electrically insulating. It may be preferred that the shell structure is electrically insulating.

The shell structure may have at least one further function selected from the group consisting of a protective cover, a mechanical shield, an environmental barrier, electromagnetic shielding, chemical barrier, thermal barrier, structural component or two or more thereof.

The shell structure can for example be made of a heat dissipating material, e.g., a polymer-based heat dissipating material. The preferred thermal conductivity of the heat dissipating material is in the range of from about 1 to about 20 W/(m*K), for example from about 1 to about 5 W/(m*K). It may however also be possible that the heat dissipating material has a thermal conductivity of up to about 500 W/(m*K), or of up to about 100 W/(m*K), or of up to about 50 W/(m*K).

Suitable polymer-based heat dissipating materials may comprise a base polymer compounded with thermally conductive reinforcements. The base polymer may for example be selected from the group consisting of poly(meth)acrylics, polyamides, nylons, acrylonitrile butadiene styrene (ABS), acrylonitrile styrene acrylates (ASA), polylactic acids (PLA), poly(lactic-co-glycolic acids), polycaprolactones (PCL), polycarbonates, polystyrenes, polyether ketone ketones (PEKK), polyether ether ketone (PEEK), polyphenyl sulfones (PPSF), polyanilines, polyvinyl ethers (PVE), epoxides, polyvinylidene fluorides (PVDF), polymethyl methacrylate (PMMA), polyacrylonitriles, polyurethanes, polyesters, polyether, polyolefins, polyphenylene oxides, thermoplastic polyurethanes (TPU), perfluoroalkoxy alkanes (PFA), polytetrafluoroethylene (PTFE) and combinations thereof.. The thermally conductive reinforcements are for example selected from non-metallic thermally conductive particles, boron nitride, graphite, diamond, aluminum oxide, zinc oxide, aluminum nitride, silver, ceramic microspheres, silicon nitride, silicon carbide and combinations thereof. The thermally conductive reinforcements are preferably non-metallic thermally conductive particles. Non-metallic thermally conductive particles are for example selected from boron nitride, aluminum oxide, aluminum nitride, silicon nitride or combinations thereof.

The heat dissipating material can be electrically insulating or electrically conductive. It can provide EMI (electromagnetic interference) / RFI (radio frequency interference) shielding properties.

Preferably, the shell material has a thickness in the range of from about 10 nm to about 10 mm in the shell structure, for example from about 50 nm to about 5 mm, more preferably from about 100 nm to about 2 mm.

The shell structures may be single layer or multilayer structures. Preferably, the shell structures are single layer structures having a thickness in the range of from about 1 to 500 micrometer, preferably 5 to 250 micrometer.

Multilayer shell structures may also be preferred. The layers may all be of the same shell material. However, it is also possible that one or more layers are of a different shell material. For example, where the shell structure is obtained by 3D printing, the shell structure is preferably a multilayer shell structure. Where the shell structure is obtained by 3D printing, the shell material is preferably 3D-printable shell material. The layers may have the same or different thickness, preferably in the range of from 1 to 500 micrometer per layer.

The combined thickness of the multilayer shell structure is preferably in the range of from about 1 mm to about 100 mm in the shell structure, for example from about 2 mm to about 70 mm, more preferably from about 5 mm to about 50 mm.

It is preferred according to the present invention that the perimeter circumscribed by the shell structure is the same or smaller than the perimeter circumscribed by the first major surface of the first element. In this context, "smaller" means that the perimeter of the rim of the shell structure contacting the first major surface of the first element does not protrude from the perimeter of the first major surface of the first element.

It is preferred according to the present invention that the perimeter circumscribed by the shell structure is the same or smaller than the perimeter circumscribed by the first major surface of the second element. In this context, "smaller" means that the perimeter of the rim of the shell structure contacting the first major surface of the second element does not protrude from the perimeter of the first major surface of the second element.

According to the present invention, the thermally conductive structure comprises a shell structure. This encompasses thermally conductive structures comprising a single shell structure. It further encompasses thermally conductive structures comprising two or more shell structures. Where two or more shell structures are comprised, they are preferably arranged in an array or pattern.

### TIM

According to the present invention, the TIM is comprised in the enclosed space. It is in direct contact with the first element via the at least one first interface area and with the second element via the at least one second interface area.

The thermal interface material can be any material that can enhance the thermal coupling between the first element and the second element when being in contact with both. The TIM preferably has a thermal conductivity in the range of from about 1 to about 40 W/(m*K), more preferably from about 1 to about 10 W/(m*K), even more preferably from about 2 to about 7 W/(m*K).

A low interfacial thermal resistance and/or high thermal contact conductance between the thermal interface material and the first element and between and between the thermal interface material and the second element are advantageous for good heat dissipation performance. Thermal resistance and thermal contact conductance can be determined by ASTM D5470-06.

Preferably, the thermal interface material may comprise a matrix and thermally conductive particles. The matrix may have a low thermal conductivity, e.g., of from about 0.1 to about 1.0 W/(m*K), preferably from 0.1 to 0.5 W(m*K), but with the inclusion of thermally conductive filler particles, the thermal conductivity of the TIM is in the range of from about 1 to about 40 W/(m*K).

The matrix can be made of a polymeric or polymerizable material.

For example, the matrix can be made of a polymerizable matrix material. The polymerizable matric material can be curable, e.g., two-part curable, UV curable, heat curable, room temperature curable, or moisture curable.

Suitable polymerizable matrix materials can for example be selected from the group consisting of alcohols, isocyanates, carboxylic acids, anhydrides, aldehydes, amines, mercaptans, olefins, epoxides, aziridines, silicones, (meth-)acrylates, vinyl ethers, ethylenically unsaturated compounds, maleimides and their corresponding oligomers and prepolymers, e.g. mixtures of different monofunctional and multifunctional acrylate ester monomers or Bisphenol A based epoxy resins like Bisphenol A diglycidyl ether (DGEBA).

It is preferred that the polymerizable matrix material is flowable prior to curing. For example, the polymerizable matrix material may be a liquid, gel, paste or foam prior to curing.

For example, the matrix can be made of a polymeric matrix material. Suitable polymeric matrix materials can for example be selected from the group consisting of polyethers, poly(meth-)acrylates, polyurethanes, epoxies, silicones, polysulfides, polyphenols, polyolefins, polyureas, melamines, polyesters, polyamides, polyimides, and combinations of two or more thereof.

The TIM prior to being introduced into the enclosed pace is preferably flowable, e.g., a liquid, gel, paste, foam or cure in place material. The thermal interface material may for example have a viscosity of up to 100 Pas, preferably of up to 50 Pas or of up to 20 Pas, when measured in a parallel plate geometry with 50 mm diameter in an oscillatory mode at 23°C with a frequency of 10 Hz and a deformation of 10%. After reaching steady state the average complex viscosity is recorded over a 180 second period and average viscosity calculated for the test duration. This limit is relevant prior to being introduced into the enclosed space. It may be preferred that the thermal interface material has a viscosity of at least 10 Pas. In the thermally conductive structure, the thermal interface material is preferably a liquid, gel, paste, foam, or cured material.

Suitable thermally conductive particles can for example be selected from the group consisting of alumina, boron nitride, graphite, copper, aluminum, silicon carbide, aluminum nitride, silicon nitride, diamond, carbon nanotubes, graphene, zincoxide, aluminum hydroxide, or combinations of two or more thereof

According to the invention, the thermally conductive particles can comprise alignable thermally conductive particles. Preferred alignable thermally conductive particles are boron nitride and graphite particles.

Thermally conductive particles according to the present invention have a mean particle size in the range of from 1 to 500, determined by ISO 13320:2020. The particle size identifies the largest dimension of the particle.

According to the present invention, the thermal interface material comprises up to about 90 wt.-% of the thermally conductive particles, preferably from about 10 to about 90 wt.-%, more preferably from about 20 to about 80 wt.-%, and at least about 10 wt.-% of the polymerizable matrix material, preferably from about 10 to about 90 wt.-%, more preferably from about 20 to about 80 wt.-%, based on the total weight of the thermal interface material.

It is also possible according to the present invention that the thermal interface material additionally comprises further components.

For example, the TIM can comprise electromagnetic wave altering particles, electrically conductive particles or other functional filler particles. Such additional particles may preferably be comprised in an amount of from about 0.1 to about 90 % by weight, based on the total weight of the thermal interface material. The functional filler particles can also be thermally conductive.

For example, the thermal interface material can additionally comprise pigments, inhibitors, accelerators, viscosity modifiers, surfactants, flow aids, flame-retardants, plasticizers and other ingredients that will be apparent to those skilled in the art.

The TIM can also be in the form of liquid metal pastes, e.g., variations of eutectic alloys composed of gallium, indium, and tin with a melting point of less than 11°C. For example, an alloy comprising 65.8 % of Ga, 21.5 % of In and 10.0 % of Zn with e melting point of - 19°C is commercially available under the trade name "Galistan".

The thermal interface material may be electrically conductive. The thermal interface material may be electrically insulating.

It is preferred according to the present invention that at least about 95 % of the first interface area are in contact with the thermal interface material, preferably at least 99% or at least about 99,9 % or at least about 99,99 %, or 100 %. It is preferred according to the present invention that at least about 95 % of the plurality of first interface areas are in contact with the thermal interface material, preferably at least about 99% or at least about 99,9 % or at least about 99,99 %, or 100 %.

It is preferred according to the present invention that at least about 95 % of the second interface area are in contact with the thermal interface material, preferably at least about 99% or at least about 99,9 % or at least about 99,99 %, or 100 %. It is preferred according to the present invention that at least about 95 % of the plurality of second interface areas are in contact with the thermal interface material, preferably at least about 99% or at least about 99,9 % or at least about 99,99 %, or 100 %.

It is preferred according to the present invention that the thermal interface material fills at least about 95 % of the enclosed space, preferably at least about 99% or at least about 99,9 % or at least about 99,99 %, or 100 %.

The present invention relates to a method of tailoring a shell structure for thermal interface materials. The method comprises
i. providing a first element and a second element, each having a first major surface, with a space between the first major surface of the first element and the first major surface of the second element;
ii. determining the three-dimensional expansion of the space;
iii. forming a shell structure suitable to fit into the space,
   so that the shell structure when inserted into the space is in contact with the first major surface of the first element and the first major surface of the second element,
   wherein the shell structure, the first major surface of the first element and the first major surface of the second element define an enclosed space,
   wherein the shell structure comprises at least one first opening which defines at least one first interface area to the first major surface of the first element,
   wherein the shell structure comprises at least one second opening which defines at least one second interface area to the first major surface of the second element,
   wherein the shell structure comprises at least one third opening between the first element and the second element.

Preferred features described for the first and second elements and the shell structure in the context of the thermally conductive structure are also preferred in the context of the method of tailoring a shell structure for thermal interface materials.

In a first step, a first element and a second element are provided. The first and second elements each have a first major surface with a space between the first major surface of the first element and the first major surface of the second element.

For the tailoring of the shell structure, the first and second elements are preferably arranged as intended in a product. This allows for making a shell structure that fits precisely between the first and second elements.

In a second step, the three-dimensional expansion of the space between the first major surface of the first element and the first major surface of the second element is determined.

The three-dimensional expansion of the space can for example be determined by 3D laser scanning, calculations, technical design, and manually with a distance measuring device.

For example, the first and second elements are preferably arranged as intended in a product, the distance between the first surface of the first element and the first surface of the second element are measured manually with a distance measuring device, the first surface of the first element is measured manually with a distance measuring device, and the first surface of the second element is measured manually with a distance measuring device. Subsequently, the three-dimensional expansion of the space between the first major surface of the first element and the first major surface of the second element is calculated.

In a third step, a shell structure is formed. The shell structure is formed so that it fits into the space between the first major surface of the first element and the first major surface of the second element.

Any known methods suitable for forming the desired shell structures are generally possible according to the present invention. It may be preferred that the shell structure is made by 3D-printing, injection moulding, casting, or subtractive processing.

The present invention relates to a method of making a heat transfer component. The method comprises
a) providing a first element having a first major surface, a second element having a first major surface, a shell structure and a liquid thermal interface material;
b) assembling the first element, the second element, the shell structure and the liquid thermal interface material, so that the shell structure is in a space between the first major surface of the first element and the first major surface of the second element and in contact with the first major surface of the first element and the first major surface of the second element,
   wherein the shell structure, the first major surface of the first element and first major surface of the second element define an enclosed space
   wherein the shell structure comprises at least one first opening which defines at least one first interface area to the first major surface of the first element,
   wherein the shell structure comprises at least one second opening which defines at least one second interface area to the first major surface of the second element,
   wherein the shell structure comprises at least one third opening between the first element and the second element, and
   wherein the liquid thermal interface material is comprised in the enclosed space, and in direct contact with the first element via the at least one first interface area and with the second element via the at least one second interface area; and;
c) optionally, curing the liquid thermal interface material.

Preferred features described for the first and second elements, the shell structure and the thermal interface material in the context of the thermally conductive structure are also preferred in the context of the method of making a heat transfer component.

In step a), first element having a first major surface, a second element having a first major surface, a shell structure and a liquid thermal interface material are provided.

It is generally possible to use any shell structure that fits into the space between first major surface of the first element and the first major surface of the second element. It may be preferred that the shell structure is provided according to the method of tailoring a shell structure as described herein.

In step b), the first element, the second element, the shell structure and the liquid thermal interface material are assembled, so that the shell structure is in a space between the first major surface of the first element and the first major surface of the second element, and the liquid thermal interface material is comprised in the enclosed space, and in direct contact with the first element via the at least one first interface area and with the second element via the at least one second interface area.

A first means for assembling the components step b) may comprise
assembling the first element, the second element and the shell structure, so that the shell structure is in a space between the first major surface of the first element and the first major surface of the second element, so that the shell structure, the first major surface of the first element and first major surface of the second element define an enclosed space, and
filling the enclosed space with a liquid thermal interface material by introducing the liquid thermal interface material into the enclosed space through the at least one third opening, wherein the liquid thermal interface material is introduced in an amount sufficient to directly contact the first element via the at least one first interface area, and the second element via the at least one second interface area.

In this case, the first element and the second element may already be in place, e.g., in a device, and the shell structure is then inserted into the space between the first major surface of the first element and the first major surface of the second element. The shell structure can for example be inserted into the space by sliding in, pushing, pulling, or placing.

For example, the shell structure may be disposed onto the first major surface of the first element, followed by disposing the second element onto the shell structure.

For example, the shell structure may be disposed onto the first major surface of the second element, followed by disposing the first element onto the shell structure.

Where the shell structure is in contact with the first major surface of the first element via a contacting component, the contacting component may be applied to the first major surface of the first element, followed by applying the shell structure to the contacting component, or the contacting component may be applied to the shell structure, followed by applying the first element to the contacting component.

Where the shell structure is in contact with the first major surface of the second element via a contacting component, the contacting component may be applied to the first major surface of the second element, followed by applying the shell structure to the contacting component, or the contacting component may be applied to the shell structure, followed by applying the second element to the contacting component.

The enclosed space is defined by the shell structure, the first major surface of the first element and first major surface of the second element. According to the invention, the enclosed is filled with a liquid thermal interface material. The liquid thermal interface material is introduced into the enclosed space through the at least one third opening of the shell structure between the first element and the second element.

The liquid thermal interface material is introduced in an amount sufficient to directly contact the first element via the at least one first interface area, and the second element via the at least one second interface area. It is preferred that the thermal interface material fills at least about 95 % of the enclosed space, preferably at least about 99% or at least about 99,9 % or at least about 99,99 %, or 100 %. It is preferred that at least about 95 % of the at least one first interface area is in contact with the thermal interface material, preferably at least about 99% or at least about 99,9 % or at least about 99,99 %, or 100 %. It is preferred that at least about 95 % of the second interface area is in contact with the thermal interface material, preferably at least about 99% or at least about 99,9 % or at least about 99,99 %, or 100 %.

According to the present invention, the liquid thermal interface material may be introduced into the enclosed space by injecting, filling, pressing, pouring or casting.

A second means for assembling the components step b) may comprise
assembling the shell structure and the first element, so that the shell structure is positioned onto the first major surface of the first element, and so that the shell structure and the first major surface of the first element define a space, wherein the second opening of the shell structure is not in contact with the first major surface of the second element;
filling the space with a liquid thermal interface material by introducing the liquid thermal interface material into the space through at least one of the second or third opening; and
positioning the first major surface of the second element onto the second opening of the shell structure, so that the shell structure, the first major surface of the first element and the first major surface of the second element define an enclosed space,
wherein the liquid thermal interface material is comprised in the enclosed space in an amount sufficient to directly contact the first element via the at least one first interface area, and the second element via the at least one second interface area.

According to the present invention, the liquid thermal interface material, may be introduced into the space by injecting, pouring, casting, or spreading.

The liquid thermal interface material can be introduced into the space through the second or third opening of the shell structure.

Preferably, an excess of liquid thermal interface material is introduced into the space. Thus, positioning the first major surface of the second element onto the second opening of the shell structure comprises compressing the liquid thermal interface material in the enclosed space.

It may be preferred that by positioning the first major surface of the second element onto the second opening of the shell structure, air and any excess of the liquid be removed through the third opening. It may also be preferred that at least part of the excess of liquid thermal interface material forms a contacting component between the shell structure and the first surface of the second element.

A third means for assembling the components step b) may comprise
assembling the shell structure and the second element, so that the shell structure is positioned onto the first major surface of the second element, and so that the shell structure and the first major surface of the second element define a space, wherein the first opening of the shell structure is not in contact with the first major surface of the first element;
filling the space with a liquid thermal interface material by introducing the liquid thermal interface material into the space through at least one of the second or third opening; and
positioning the first major surface of the first element onto the first opening of the shell structure, so that the shell structure, the first major surface of the first element and the first major surface of the second element define an enclosed space,
wherein the liquid thermal interface material is comprised in the enclosed space in an amount sufficient to directly contact the first element via the at least one first interface area, and the second element via the at least one second interface area.

According to the present invention, the liquid thermal interface material, may be introduced into the space by injecting, pouring, casting, or spreading.

The liquid thermal interface material can be introduced into the space through the first or third opening of the shell structure.

Preferably, an excess of liquid thermal interface material is introduced into the space. Thus, positioning the first major surface of the first element onto the first opening of the shell structure comprises compressing the liquid thermal interface material in the enclosed space.

It may be preferred that by positioning the first major surface of the first element onto the first opening of the shell structure, air and any excess of the liquid be removed through the third opening. It may also be preferred that at least part of the excess of liquid thermal interface material forms a contacting component between the shell structure and the first surface of the first element.

According to step c), liquid thermal interface material may optionally be cured. Thus, the thermally conductive structure comprises a thermal interface material either in liquid or in cured form.

It may be preferred that the thermally conductive structure comprises a liquid thermal interface material.

It may be preferred according to the present invention that the method of making a thermally conductive structure comprises curing the liquid thermal interface material. In this case, the thermally conductive structure obtained by the proceed according to the present invention comprises a cured thermal interface material in the enclosed space.

For example, the liquid thermal interface material can be cured by thermal treatment, chemical treatment, UV treatment, light treatment, reactive gas treatment or pH change treatment. Preferably the liquid thermal interface material is UV curable or heat curable.

It is also possible according to the present invention that curing of a two-component TIM formulation is initiated by mixing. A two-component TIM formulation can for example cure after mixing due to an initiator being comprised in a first component of the two-component formulation and the curable polymer comprised in the second component of the two-component formulation.

The present invention relates to an electronic device. The electronic device comprises a thermally conductive structure or a heat dissipation device as described above.

Preferred electronic devices are computers, semiconductor devices, transistors, CPU's (central processing units), GPU's (graphics processing units), COB (chips on board) LED's, CPU's coupled with a cooler, battery charging systems, battery system including cells and electrical connections and antennas.

### Detailed description of the Figures

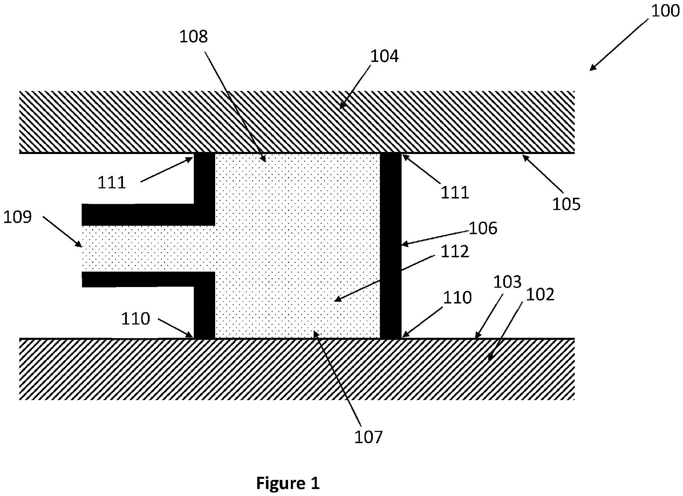

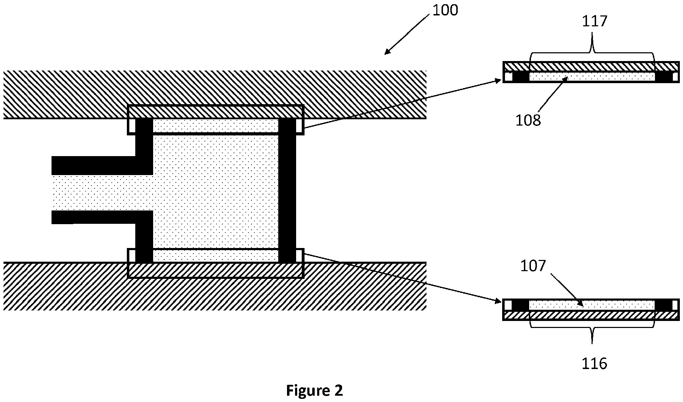

Figure 1 is a side view of a thermally conductive structure 100. Figure 2 is a detailed side view of the first interface area 116 and second interface area 117 of a thermally conductive structure 100. The thermally conductive structure 100 comprises a first element 102 having a first major surface 103, and a second element 104 having a first major surface 105.

The thermally conductive structure 100 further comprises a shell structure 106. The shell structure 106 is in contact 110 with the first major surface 103 of the first element 102, and in contact 111 with the first major surface 105 of the second element 104. The shell structure 106 comprises a first opening 107 which defines a first interface area 116 to the first major surface 103 of the first element 102. The shell structure 106 comprises a second opening 108 which defines a second interface area 117 to the first major surface 105 of the second element 104. The shell structure 106 comprises a third opening 109 between the first element 102 and the second element 104.

The thermally conductive structure 100 further comprises a thermal interface material 112. The thermal interface material 112 is comprised in the enclosed space defined by the shell structure 106, the first major surface 103 of the first element 102 and the first major surface 105 of the first element 104. The thermal interface material 112 is in direct contact with the first element 102 via the first interface area 116 and with the second element 104 via the second interface area 117.

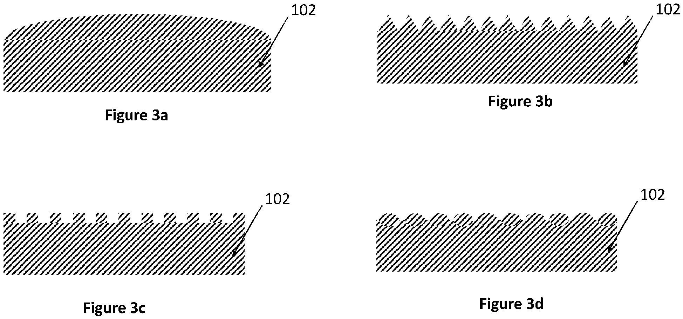

Figure 3 shows different surface structures of the first major surface of the first element 102. Figure 3a shows a concave first major surface of the first element. Figure 3b shows triangular protrusions on the first major surface of the first element. Figure 3c shows rectangular protrusions on the first major surface of the first element. Figure 3d shows semi-spheric protrusions on the first major surface of the first element.

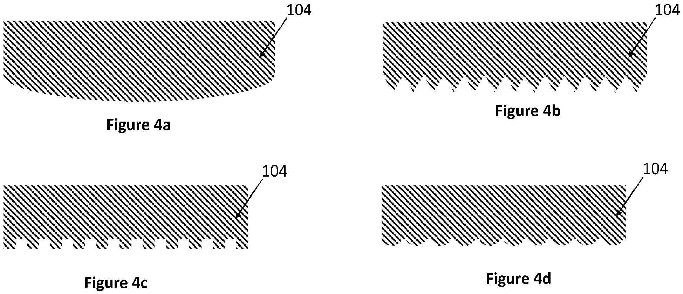

Figure 4 shows different surface structures of the first major surface of the second element 104. Figure 4a shows a concave first major surface of the second element. Figure 4b shows triangular protrusions on the first major surface of the second element. Figure 4c shows rectangular protrusions on the first major surface of the second element. Figure 4d shows semi-spheric protrusions on the first major surface of the second element.

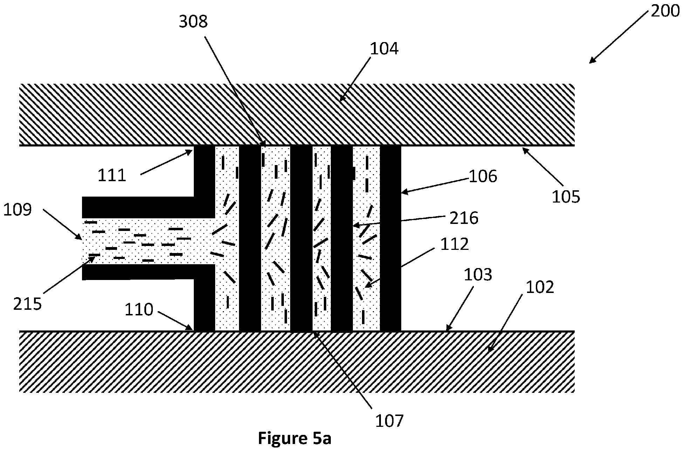

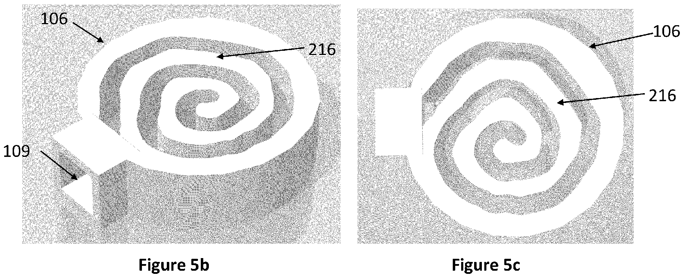

Figure 5a is a side view of a thermally conductive structure 200 comprising alignable thermally conductive particles 215. Due to the injection flow, the thermally conductive particles 215 automatically align in the desired direction pointing from the first element to the second element, thereby allowing for excellent thermal conduction. Accurate alignment of alignable thermally conductive particles can preferably be achieved when the shell structure has internal structures 216 that guide the flow of the thermal interface material comprising thermally conductive particles. Figures 5b and 5c shows the internal structures 216 of the shell structure 106 shown in Figure 5a. The internal structures 216 are in the form of a spiral.

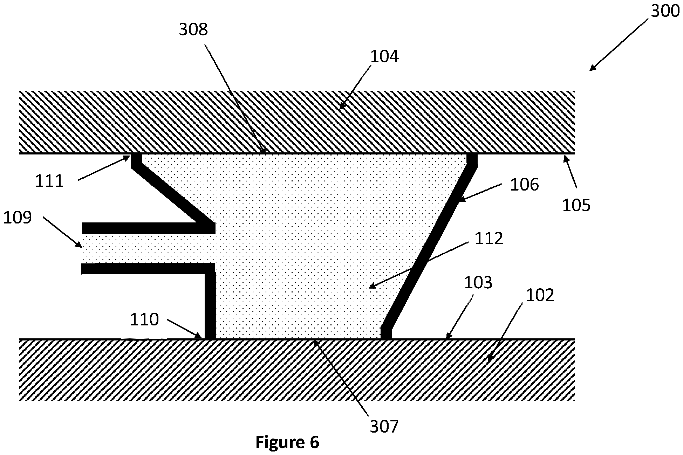

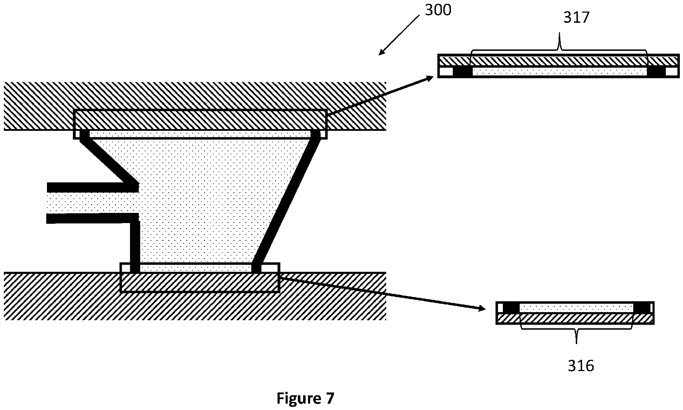

Fig. 6 is a side view of a thermally conductive structure 300 having a first interface area 316 that is different from the second interface area 317. Accordingly, the first opening 307 of the shell structure 106 is smaller than the second opening 308 of the shell structure 106. Figure 7 is a detailed side view of the first interface area 316 and second interface area 317 of the thermally conductive structure 300.

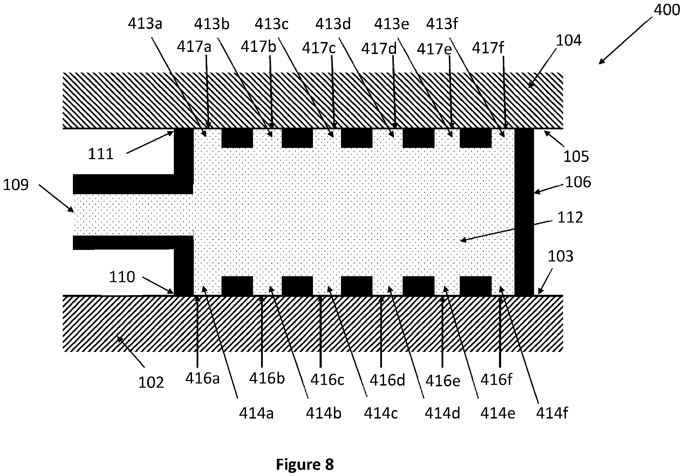

Figure 8 is a side view of a thermally conductive structure 400 having pluralities of first openings 414a-f and second openings 413a-f. Accordingly, the thermally conductive structure 400 has a plurality of first interface areas 416a-f and second openings 417a-f.

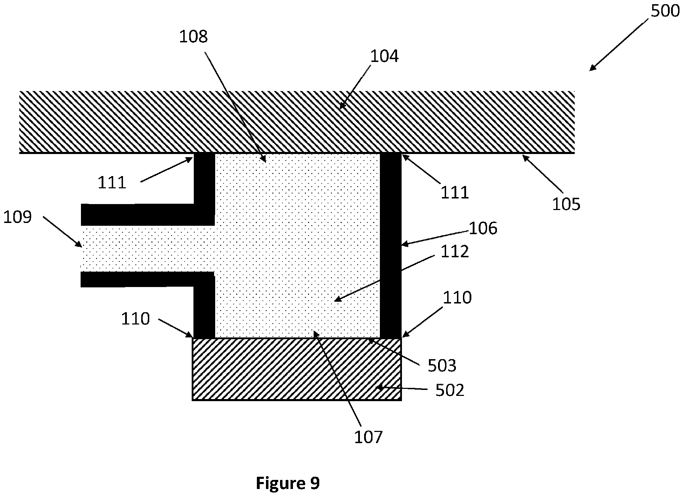

Figure 9 is a side view of a thermally conductive structure 500. Therein, the perimeter of the rim of the shell structure contacting the first major surface 503 of the first element 502 is the same as the perimeter circumscribed by the first major surface 503 of the first element 502. The perimeter of the rim of the shell structure contacting the first major surface 503 of the first element 502 does not protrude from the perimeter of the first major surface 503 of the first element 502.

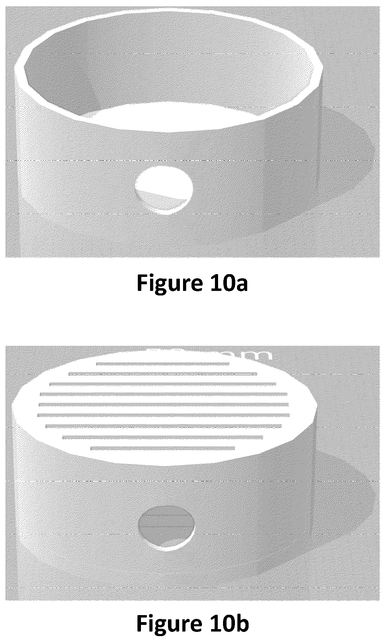

Figure 10a shows a cylinder-shaped shell structure. The shell structure has a single first opening at one end of the cylinder, a single second opening at the other end of the cylinder, and a third opening in the wall.

Figure 10b shows a cylinder-shaped shell structure. The shell structure has a single first opening at one end of the cylinder, a plurality of slit-shaped second openings at the other end of the cylinder, and a third opening in the wall.

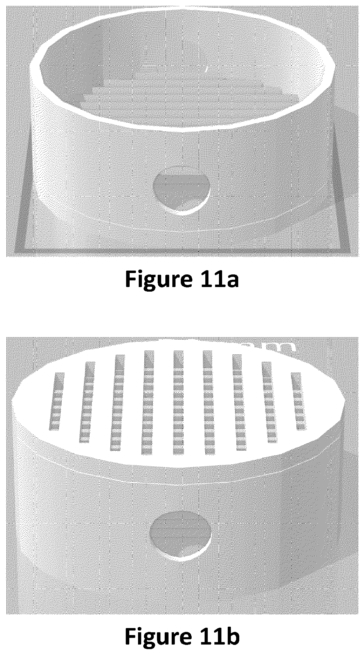

Figures 11a and 11b show a cylinder-shaped shell structure. Figure 11a represents the view inside the cylinder from the top. Figure 11a also shows inner design features of the shell structure that allow for hexagonal boron nitride alignment. Figure 11b represents the view onto the cylinder, i.e., it is also the view from the top, wherein the upper lid having a slit-like plurality of second openings is shown. Through the slits, the inner design features are also visible.

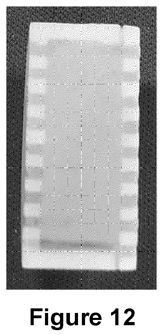

Figure 12 shows a top view of a cuboid shell structure with a single first opening at one end of the cuboid. The shell structure is filled with a TIM.

### Exemplary Embodiments

A. A thermally conductive structure comprising
   a. a first element having at least a first major surface;
   b. a second element having at least a first major surface;
   c. a shell structure between the first element and the second element, and in contact with the first major surface of the first element and the first major surface of the second element,
      wherein the shell structure, the first major surface of the first element and the first major surface of the second element define an enclosed space,
      wherein the shell structure comprises at least one first opening which defines at least one first interface area to the first major surface of the first element,
      wherein the shell structure comprises at least one second opening which defines at least one second interface area to the first major surface of the second element,
      wherein the shell structure comprises at least one third opening between the first element and the second element; and
   d. a thermal interface material (TIM) comprised in the enclosed space, and in direct contact with the first element via the at least one first interface area and with the second element via the at least one second interface area.
B. The thermally conductive structure according to embodiment A, wherein the temperature of the first element increases during use.
C. The thermally conductive structure according to any one of the preceding embodiments, wherein the first element is selected from the group consisting of CPU's, battery elements, LED's, bus bars, antenna or other electrical components needing cooling.
D. The thermally conductive structure according to any one of the preceding embodiments, wherein the second element is an element designed to dissipate heat, preferably selected from substrates, heat sinks, heat exchangers or heat dissipators.
E. The thermally conductive structure according to any one of the preceding embodiments, wherein the shell structure is in direct contact with the first major surface of the first element, with the first major surface of the second element, or with both.
F. The thermally conductive structure according to any one of embodiments A to D, wherein the shell structure is in contact with the first major surface of the first element, with the first major surface of the second element, or with both via a contacting component selected from the group consisting of adhesives, sealants, thermally conductive materials, thermally insulating materials, electrically conductive materials, electrically insulating materials, electromagnetic shielding materials, electromagnetic transparent materials, electromagnetic redirecting materials, and thermal interface materials.
G. The thermally conductive structure according to any one of the preceding embodiments, wherein the shell structure comprises a single first opening which defines a single first interface area to the first major surface of the first element.
H. The thermally conductive structure according to any one of the preceding embodiments, wherein the shell structure comprises a single second opening which defines a single second interface area to the first major surface of the second element.
I. The thermally conductive structure according to any one of claim embodiments A to F or H, wherein the shell structure comprises a plurality of first openings which define a plurality of first interface areas to the first major surface of the first element, preferably wherein the plurality of first openings is patterned.
J. The thermally conductive structure according to any one of embodiments A to G or I, wherein the shell structure comprises a plurality of second openings which define a plurality of second interface areas to the first major surface of the second element, preferably wherein the plurality of second openings is patterned.
K. The thermally conductive structure according to embodiment J, wherein the pattern of the plurality of first openings and the pattern of the plurality of second openings is identical.
L. The thermally conductive structure according to embodiment J, wherein the pattern of the plurality of first openings and the pattern of the plurality of second openings is different.
M. The thermally conductive structure according to any one of the preceding embodiments, wherein the shortest distance between the first major surface of the first element being in direct contact with the thermal interface material and the first major surface of the second element being in direct contact with the thermal interface material is in the range of from 0.1 mm to 250 mm, 1 mm to 100 mm, 10 mm to 50 mm.
N. The thermally conductive structure according to any one of the preceding embodiments, wherein the shell structure is made of a 3D-printable shell material.
O. The thermally conductive structure according to any one of the preceding embodiments, wherein the shell material comprises a metal, ceramic, polymer or polymer matrix composite with the polymer being selected from the group consisting of poly(meth)acrylics, polyamides, nylons, acrylonitrile butadiene styrene (ABS), acrylonitrile styrene acrylates (ASA), polylactic acids (PLA), poly(lactic-co-glycolic acids), polycaprolactones (PCL), polycarbonates, polystyrenes, polyether ketone ketones (PEKK), polyether ether ketone (PEEK), polyphenyl sulfones (PPSF), polyanilines, polyvinyl ethers (PVE), epoxides, polyvinylidene fluorides (PVDF), polymethyl methacrylate (PMMA), polyacrylonitriles, polyvinyl chlorides, polyurethanes, polyesters, polyether, polyolefins, polyphenylene oxides, thermoplastic polyurethanes (TPU), perfluoroalkoxy alkanes (PFA), polytetrafluoroethylene (PTFE) and any combinations or mixtures thereof.
P. The thermally conductive structure according to any one of the preceding embodiments, wherein the shell material has a thickness in the range of from 0.1 mm to 10 mm, preferably from 0.1 mm to 2 mm in the shell structure.
Q. The thermally conductive structure according to any one of the preceding embodiments, wherein the thermal interface material (TIM) is a liquid, gel, paste, foam, cured material or cure in place material.
R. The thermally conductive structure according to any one of the preceding embodiments, wherein the thermal interface material (TIM) is a heat transmitting material having a high inherent thermal conductivity, preferably in the range of from 1 to 10 W/(m*K), preferably 2-7 W/(m*K).
S. The thermally conductive structure according to any one of the preceding embodiments, wherein the thermal interface material (TIM) comprises a matrix and thermally conductive particles.
T. The thermally conductive structure according to embodiment S, wherein the matrix is made of a polymerizable matrix material, wherein the polymerizable matrix material is curable, preferably two part curable, UV curable, heat curable room temperature curable, moisture curable, preferably wherein the polymerizable matrix material is selected from alcohols, isocyanates, carboxylic acids, anhydrides, aldehydes, amines, mercaptans, olefins, epoxides, aziridines, silicones, (meth)acrylates, maleimides, and their corresponding oligomers and prepolymers.
U. The thermally conductive structure according to embodiment S, wherein the matrix is made of a polymeric matrix material which is selected from the group consisting of polyethers, poly(meth-)acrylates, polyurethanes, epoxies, silicones, polysulfides polyphenols, polyolefins, polyureas, melamines, polyesters, polyamides, polyimides, and combinations of two or more thereof.
V. The thermally conductive structure according to any one of embodiments S to U, wherein the thermally conductive particles are selected from the group consisting of alumina, boron nitride, graphite, copper, aluminum, silicon carbide, aluminum nitride, silicon nitride, diamond, carbon nanotubes, graphene, zinc-oxide, aluminum hydroxide, or combinations of two or more thereof.
W. The thermally conductive structure according to any one of embodiments S to V, wherein the thermally conductive particles comprise alignable thermally conductive particles, preferably boron nitride or graphite particles.
X. The thermally conductive structure according to any one of embodiments S to W, wherein the thermal interface material comprises from 10 to 90 wt.-% of thermally conductive particles, and from 10 to 90 wt.-% of the polymeric or polymerizable matrix material, based on the total weight of the thermal interface material.
Y. The thermally conductive structure according to any one of the preceding embodiments, wherein at least 95 % of the first interface area are in contact with the thermal interface material, preferably at least 99% or at least 99,9 % or at least 99,99 %, or 100 %.
Z. The thermally conductive structure according to any one of the preceding embodiments, wherein at least 95 % of the second interface area are in contact with the thermal interface material, preferably at least 99% or at least 99,9 % or at least 99,99 %, or 100 %.
AA. The thermally conductive structure according to any one of the preceding embodiments comprising a single shell structure.
BB. The thermally conductive structure according to any one of embodiments A to Z comprising two or more shell structures.
CC. The thermally conductive structure according to embodiment BB, wherein the two or more shell structures are arranged in an array or pattern.
DD. Method of tailoring a shell structure for thermal interface materials comprising
   i. providing a first element and a second element, each having a first major surface, with a space between the first major surface of the first element and the first major surface of the second element;
   ii. determining the three-dimensional expansion of the space;
   iii. forming a shell structure suitable to fit into the space,
      so that the shell structure when inserted into the space is in contact with the first major surface of the first element and the first major surface of the second element,
      wherein the shell structure, the first major surface of the first element and the first major surface of the second element define an enclosed space,
      wherein the shell structure comprises at least one first opening which defines at least one first interface area to the first major surface of the first element,
      wherein the shell structure comprises at least one second opening which defines at least one second interface area to the first major surface of the second element,
      wherein the shell structure comprises at least one third opening between the first element and the second element.
EE. The method according to embodiment DD, wherein the shell structure is made by 3D-printing, injection moulding, subtractive processing (milling).
FF. Method of making a thermally conductive structure comprising
   a) providing a first element having a first major surface, a second element having a first major surface, a shell structure and a liquid thermal interface material;
   b) assembling the first element, the second element, the shell structure and the liquid thermal interface material, so that the shell structure is in a space between the first major surface of the first element and the first major surface of the second element and in contact with the first major surface of the first element and the first major surface of the second element,
      wherein the shell structure, the first major surface of the first element and first major surface of the second element define an enclosed space,
      wherein the shell structure comprises at least one first opening which defines at least one first interface area to the first major surface of the first element,
      wherein the shell structure comprises at least one second opening which defines at least one second interface area to the first major surface of the second element,
      wherein the shell structure comprises at least one third opening between the first element and the second element, and
      wherein the liquid thermal interface material is comprised in the enclosed space, and in direct contact with the first element via the at least one first interface area and with the second element via the at least one second interface area; and
   c) optionally, curing the liquid thermal interface material.
GG. The method according to embodiment FF, wherein the shell structure is provided by the tailoring method according to any one of embodiments DD to EE.
HH. The method according to any one of embodiments FF to GG, wherein step b) comprises
   assembling the first element, the second element and the shell structure, so that the shell structure is in a space between the first major surface of the first element and the first major surface of the second element, so that the shell structure, the first major surface of the first element and first major surface of the second element define an enclosed space, and
   filling the enclosed space with a liquid thermal interface material by introducing the liquid thermal interface material into the enclosed space through the at least one third opening, wherein the liquid thermal interface material is introduced in an amount sufficient to directly contact the first element via the at least one first interface area, and the second element via the at least one second interface area.
II. The method according to embodiment HH, wherein the liquid thermal interface material is introduced into the enclosed space by injecting, pouring, or casting.
JJ. The method according to any one of embodiments FF to GG, wherein step b) comprises
   assembling the shell structure and the first element, so that the shell structure is positioned onto the first major surface of the first element, and so that the shell structure and the first major surface of the first element define a space, wherein the second opening of the shell structure is not in contact with the first major surface of the second element;
   filling the space with a liquid thermal interface material by introducing the liquid thermal interface material into the space through at least one of the second or third opening; and
   positioning the first major surface of the second element onto the second opening of the shell structure, so that the shell structure, the first major surface of the first element and the first major surface of the second element define an enclosed space,
   wherein the liquid thermal interface material is comprised in the enclosed space in an amount sufficient to directly contact the first element via the at least one first interface area, and the second element via the at least one second interface area.
KK. The method according to embodiment JJ, wherein positioning the first major surface of the second element onto the second opening of the shell structure comprises compressing the liquid thermal interface material in the enclosed space.
LL. The method according to any one of embodiments FF to GG, wherein step b) comprises
   assembling the shell structure and the second element, so that the shell structure is positioned onto the first major surface of the second element, and so that the shell structure and the first major surface of the second element define a space, wherein the first opening of the shell structure is not in contact with the first major surface of the first element;
   filling the space with a liquid thermal interface material by introducing the liquid thermal interface material into the space through at least one of the second or third opening; and
   positioning the first major surface of the first element onto the first opening of the shell structure, so that the shell structure, the first major surface of the first element and the first major surface of the second element define an enclosed space,
   wherein the liquid thermal interface material is comprised in the enclosed space in an amount sufficient to directly contact the first element via the at least one first interface area, and the second element via the at least one second interface area.
MM. The method according to any one of embodiments JJ to LL, wherein the liquid thermal interface material is introduced into the space by injecting, pouring, casting, or spreading.
NN. The method according to any one of embodiments LL to MM, wherein positioning the first major surface of the first element onto the first opening of the shell structure comprises compressing the liquid thermal interface material in the enclosed space.
OO. An electronic device comprising a thermally conductive structure according to any one of embodiments A to CC.

### EXAMPLES

Unless otherwise noted or readily apparent from the context, all parts, percentages, ratios, etc. in the Examples and the rest of the specification are by weight. Table 1, below, reports materials and abbreviations used in the Examples.

**TABLE 1**

| ABBREVIATION | DESCRIPTION AND SOURCE |
|---|---|
| CFF 200-3 | Hexagonal boron nitride, obtained as BORON NITRIDE COOLING FILLER FLAKES CFF 200-3 from 3M Company; St. Paul, Minnesota |
| TM1250 | Aluminum oxide with a mean diameter of 1.6 micrometer, obtained as MARTOXID TM1250 from Huber Martinswerk; Bergheim, Germany |
| BAK10 | Spherical Aluminum oxide with a mean diameter of 10 micrometer, obtained as BAK10 from Bestry; Sichuan, China |
| BAK70 | Spherical Aluminum oxide with a mean diameter of 70 micrometer, obtained as BAK70 from Bestry |
| DB-108 | Hydroxy-functional carboxylic acid ester obtained as DISPERBYK-108 from BYK Chemistry; Wesel, Germany |
| AZISI | Bis[3-ethyleniminopropylamido-oxalamidopropyl-(dimethylsiloxy])-polydimethylsiloxane) having a number average molecular weight of about 3000 g/mol, prepared generally according to procedures in pending application PCT/IB2020/060330 filed November 4, 2020 and entitled " Thermally-Conductive Curable Composition" |
| TEHABS | Tris(2-ethylhexyl)ammonium alkyl(C₁₁-C₁₃)benzenesulfonate, prepared according to the general method disclosed in WO 2020-095170 A1 (Bissinger et al.) |
| SR540 | ETHOXYLATED (4) BISPHENOL A METHACRYLATE SR540, obtained from Sartomer, Colombes, France |
| TRGDMA | Triethyleneglycol dimethacrylate, obtained from Merck, Darmstadt, Germany |
| DESMA | Polyurethane methacrylate (cas no. 1101874-33-2) obtained according to [0153] of EP 2167013 B1 ("Typical synthesis of Compound (A1) - (Example 1; DESMA)") |
| MA1 | Mixed polyetherdiol (cas no. 165305-27-1) obtained according to [0032]-[0034] of EP 0670341 B1 ("Beispiel 1 (Prepolymer)"), based on ethylene oxide, tetrahydrofurane and bis(2-methyl-2propenoate) |
| HPMA | Mixture of hydroxypropyl and hydroxyisopropyl methacrylates, obtained from Merck, Darmstadt, Germany |
| Omnirad 819 | Bis(2,4,6-Trimethylbenzoyl)phenylphosphine oxide Omnirad 819, obtained from IGM Resins, Waalwijk, Netherlands |
| isopropanol | isopropanol, obtained from Merck, Darmstadt, Germany |
| 3DP Resin | Mixture consisting of 38.4 wt.-% SR540, 38.4 wt.-% TRGDMA, 13.2 wt.-% DESMA, 8 wt.-% HPMA, 2 wt.-% MA1 |
| Lumilux Blue LZ | Pigment, obtained from Honeywell Specialty Chemicals Seelze GmbH, Seelze, Germany |
| Cab-O-Sil TS-720 | Fumed Silica, obtained from Cabot Corporation, Boston, MA |

### EXAMPLE 1: Preparation of the TIM

Example 1 was prepared by mixing 2.86 g of AZISI and 0.22 g DB-108 in a high shear mixer (obtained as DAC SPEEDMIXER 400.2 VAC-P from Hauschild, Hamm, Germany) at 2500 rpm for 30 s.

Afterwards, alumina fillers were added consecutively in the following order: 4.19 g of TM1250, 4.19 g of BAK10, 12.56 g of BAK70. After each filler addition, the container was mixed at 2500 rpm for 30 s. After the mixture was cooled down to room temperature, it was further mixed under reduced pressure of 50 mbar (5.0 kPa) at 1000 rpm for 2 min.

1.00 g of CFF 200-3 and 0.06 g of TEHABS were added to the cooled down mixture and it was again mixed at 2500 rpm for 30 s.

Immediately after mixing, the samples were further processed.

### EXAMPLE 2: Preparation processing and measurement of a UV curable 3D printing material

Two batches consisting of 38.6 g 3DP Resin, 160.6 g BAK 10, 0.38 g Cab-O-Sil TS-720, 0.1 g Omnirad 819 and 0.18 g Lumilux Blue LZ were mixed in a DAC 400 FVZ / VAC-P / LR Speedmixer (Hauschild GmbH, Hamm, Germany) for 3 minutes at 2500 rpm at 400 mbar and combined afterwards.

This mixture was filled into a D30II 3D printer (Rapid Shape GmbH, Heimsheim, Germany) directly after mixing and the print job was started.

Printjob preparation was done with Netfabb 2019 (Autodesk, San Rafael, CA) with the following parameters: energy dose: 800 mJ/dm², support width: 200 µm, Offset: 0 µm, shrinkage: 0.6 %, Z-compensation: 0 µm, layer size: 25 µm, burn in factor: 500 %.

3D printed parts were carefully removed from the platform after printing and transferred into a closable container containing isopropanol. This container was transferred into a Sonorex Super RK 1028 BH ultrasonic bath (Bandelin electronic GmbH, Berlin, Germany) filled with water and exposed to ultra sonic for 15 min. Afterwards, parts were removed from the container and residual 3D printing material and isopropanol were removed using compressed air. This procedure was done two times.

After cleaning the part, it was post cured in a RS Cure UV curing chamber (Rapid Shape GmbH, Heimsheim, Germany) using both wavelengths at maximum intensity under vacuum for 1200 s.

### EXAMPLE 3: Combining TIM material with shell structure

The shell structure consists of two components, as shown for example in Figure 11. The components are the top component with the first opening and the bottom component with the second opening.

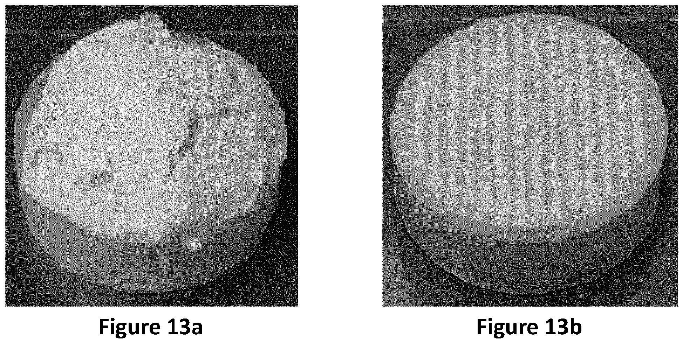

The shell structure has a third opening at the side. The TIM material is filled into the bottom component until the bottom element is filled with the TIM material beyond its limits (see Figure 13a).

The top component of the shell structure in which the first opening is located is pressed onto the bottom component with the second opening. The TIM emerges from the first and second openings as well as from the third opening. The excess TIM is wiped off the openings (see Figure 13b). The filled shell structure is left for curing for 24h.

The thermal conductivity from the first to the second opening was measured according to ASTM D5470-17. Values of 1.7 W/mK ± 0.1 W/mK were achieved.

## Claims

1. A thermally conductive structure comprising
a. a first element having at least a first major surface;
b. a second element having at least a first major surface;
c. a shell structure between the first element and the second element, and in contact with the first major surface of the first element and the first major surface of the second element,
wherein the shell structure, the first major surface of the first element and the first major surface of the second element define an enclosed space,
wherein the shell structure comprises at least one first opening which defines at least one first interface area to the first major surface of the first element,
wherein the shell structure comprises at least one second opening which defines at least one second interface area to the first major surface of the second element,
wherein the shell structure comprises at least one third opening between the first element and the second element; and
d. a thermal interface material (TIM) comprised in the enclosed space, and in direct contact with the first element via the at least one first interface area and with the second element via the at least one second interface area.

2. The thermally conductive structure according to claim 1, wherein the temperature of the first element increases during use.

3. The thermally conductive structure according to any one of the preceding claims, wherein the shell structure is in direct contact with the first major surface of the first element, with the first major surface of the second element, or with both.

4. The thermally conductive structure according to any one of claims 1 or 2, wherein the shell structure is in contact with the first major surface of the first element, with the first major surface of the second element, or with both via a contacting component selected from the group consisting of adhesives, sealants, thermally conductive materials, thermally insulating materials, electrically conductive materials, electrically insulating materials, electromagnetic shielding materials, electromagnetic transparent materials, electromagnetic redirecting materials, and thermal interface materials.

5. The thermally conductive structure according to any one of the preceding claims, wherein the shortest distance between the first major surface of the first element being in direct contact with the thermal interface material and the first major surface of the second element being in direct contact with the thermal interface material is in the range of from 0.1 mm to 250 mm, 1 mm to 100 mm, 10 mm to 50 mm.

6. The thermally conductive structure according to any one of the preceding claims, wherein the shell structure is made of a 3D-printable shell material.

7. The thermally conductive structure according to any one of the preceding claims, wherein the shell material has a thickness in the range of from 0.1 mm to 10 mm, preferably from 0.1 mm to 2 mm in the shell structure.

8. The thermally conductive structure according to any one of the preceding claims, wherein the thermal interface material (TIM) comprises a matrix and thermally conductive particles.

9. The thermally conductive structure according to claim 8, wherein the thermally conductive particles are selected from the group consisting of alumina, boron nitride, graphite, copper, aluminum, silicon carbide, aluminum nitride, silicon nitride, diamond, carbon nanotubes, graphene, zinc-oxide, aluminum hydroxide, or combinations of two or more thereof.

10. The thermally conductive structure according to any one of claims 8 to 9, wherein the thermally conductive particles comprise alignable thermally conductive particles, preferably boron nitride or graphite particles.

11. The thermally conductive structure according to any one of claims 8 to 10, wherein the thermal interface material comprises from 10 to 90 wt.-% of thermally conductive particles, and from 10 to 90 wt.-% of the polymeric or polymerizable matrix material, based on the total weight of the thermal interface material.

12. Method of tailoring a shell structure for thermal interface materials comprising
i. providing a first element and a second element, each having a first major surface, with a space between the first major surface of the first element and the first major surface of the second element;
ii. determining the three-dimensional expansion of the space;
iii. forming a shell structure suitable to fit into the space,
so that the shell structure when inserted into the space is in contact with the first major surface of the first element and the first major surface of the second element,
wherein the shell structure, the first major surface of the first element and the first major surface of the second element define an enclosed space,
wherein the shell structure comprises at least one first opening which defines at least one first interface area to the first major surface of the first element,
wherein the shell structure comprises at least one second opening which defines at least one second interface area to the first major surface of the second element,
wherein the shell structure comprises at least one third opening between the first element and the second element.

13. Method of making a thermally conductive structure comprising
a) providing a first element having a first major surface, a second element having a first major surface, a shell structure and a liquid thermal interface material;
b) assembling the first element, the second element, the shell structure and the liquid thermal interface material, so that the shell structure is in a space between the first major surface of the first element and the first major surface of the second element and in contact with the first major surface of the first element and the first major surface of the second element,
wherein the shell structure, the first major surface of the first element and first major surface of the second element define an enclosed space,
wherein the shell structure comprises at least one first opening which defines at least one first interface area to the first major surface of the first element,
wherein the shell structure comprises at least one second opening which defines at least one second interface area to the first major surface of the second element,
wherein the shell structure comprises at least one third opening between the first element and the second element, and
wherein the liquid thermal interface material is comprised in the enclosed space, and in direct contact with the first element via the at least one first interface area and with the second element via the at least one second interface area; and
c) optionally, curing the liquid thermal interface material.

14. The method according to claim 13, wherein the shell structure is provided by the tailoring method according to claim 12.

15. An electronic device comprising a thermally conductive structure according to any one of claims 1 to 11.
